# EUROPEAN PATENT APPLICATION

(11) **EP 2 549 525 A1**
(43) Date of publication of application: **23.01.2013**
(21) Application number: 11174396.9
(22) Date of filing: 18.07.2011
(51) Int. Cl.: H01L 21/311, H01L 21/3065

(54) **Process for the production of etched items using CHF3**

(71) Applicant: SOLVAY SA, 1120 Bruxelles (BE)
(72) Inventor: The designation of the inventor has not yet been filed
(74) Representative: Mross, Stefan P.M.

(57) **Abstract**

Disclosed is process for producing an etched item having a sub-micron photoresist layer comprising a step of plasma etching of an inorganic substrate, e.g. a silicon oxide layer or a silicon nitride layer, wherein the etchant composition comprises COF₂ and CHF₃ and optionally a diluent and/or an oxygen compound. The etchant composition of the present invention provides improved etching characteristics and enable etching sub-micron layer.

## Description

### BACKGROUND OF THE INVENTION

The present invention concerns a process for the preparation of etched items, e.g. semiconductors, photovoltaic cells, display panels, and micro-electromechanical systems, and a composition of matter suitable as etchant composition. During the manufacture of semiconductors, photovoltaic cells, display panels, and micro-electromechanical systems (MEMS), one or more steps of etching must be performed. Often, the materials to be etched are silicon, silicon oxide, silicon nitride, or low-k dielectrics, for example, FSG (fluorosilicate glass), or C-doped silicon dioxide. One preferred method of etching the items is performed using plasma in the presence of an etchant.

JP Kokai Hei 5-326460 discloses a process for dry-etching silicon compound layer by using etching gas comprising, in molecule, fluorocarbon compound and inorganic halogen compound containing at least one functional group selected from a group consisted of carbonyl, thionyl, sulfuryl, nitrosyl and nitryl, and halogen atom. However, it does not disclose a thickness of the layer to be etched, or a general range of the volume ratio of the mixture gases.

### DESCRIPTION OF THE INVENTION

It is the object of the present invention to provide an efficient process for plasma-etching using etching compositions, especially for use in etching sub-micron layer. In one aspect, the present invention provides a process for producing an etched item having a submicron photoresist coating comprising a step of plasma etching at least one inorganic substrate with an etchant composition, wherein the etchant composition comprises COF₂ and CHF₃.

In the present invention, the term "an item" includes the singular and the plural, especially one item or a plurality of items, e.g. 2, 3, 4, 5 or more items. If only one item or a plurality of items are etched, appropriate plasma chamber can be used depending on the capacity of the plasma chamber. If multiple items shall be etched simultaneously, a respective plasma chamber must be applied.

In the present invention, the terms "comprising" and "containing" include the meaning of "consisting of."

In the present invention, the singular form includes the plural form and vice versa unless otherwise indicated. In the present invention, the term "sub-micron" is understood to denote a meaning generally accepted in the art. Preferably, a range of the "sub-micron" is from 1 nm to 999 nm. Still more preferably, the thickness of the photoresist is equal to or lower than 500 nm. Still more preferably, the thickness of the photoresist is equal to or greater than 100 nm. In one aspect of the invention, the content of CHF₃ is equal to or greater than 5 % by volume, when the total amount of CHF₃ and COF₂ is set to 100 vol.- %. Preferably, it is equal to or lower than 40 % by volume. More preferably, the content of CHF₃ is in a range of 5∼40 %, preferably 10∼40 %, more preferably 15∼40 % when the total amount of CHF₃ and COF₂ is set to 100 vol.- %. The process of the present invention can be performed such that a mixture of COF₂ and CHF₃ is fed into the plasma apparatus. Alternatively, COF₂ and CHF₃ are fed separately into the plasma apparatus.

Often, the selectivity of COF₂ to photo-resist is too low for etching sub-micron layers. One of the advantages of the addition of CHF₃, is the improvement of the selectivity to the photo-resist, enabling the process of plasma-etching for sub-micron layer.

The inorganic substrate may be, for example, silicon, silicon dioxide or silicon nitride, or a low-k dielectric as given above.

The process of the invention can be used to etch any photo resist made from organic material, e.g. photoresists based on poly(methyl methacrylate), poly(methyl glutarimide) or based on phenol formaldehyde resins, including those resins comprising a diazonaphthoquinone photoactive compound (PAC). Preferably, the photoresist is of the "positive" type, based on PAC/phenol formaldehyde resins. Here, the portion of the photoresist that is exposed to light becomes soluble to the photoresist developer (which usually is an aqueous composition, e.g. 0.262 N tetramethyl ammonium hydroxide (TMAH)).

The process can be applied to perform microfabrication of semiconductor-based logic, memory and optoelectronic devices and micromechanical systems using anisotropic etching.

The process of the invention, according to one aspect of the invention, is especially suitable to etch substrates in the manufacture of semiconductors, photovoltaic cells, thin film transistor (TFT) display panels and micro-electromechanical systems. The term "substrate" denotes, for example, that solar cells, usually manufactured from monocrystalline blocks of boron-doped silicon (P-type doping) or from cast silicon ingots (polycrystalline silicon, P-type doped with boron) by sawing wafers in desired size out of the bulk material wherein optionally silicon doped with phosphorous is formed to provide an N-type doped coating; semiconductors. The term "substrate" further denotes TFT for displays ; micro-electromechanical devices or machines, for example, for inkjet printers operating with piezoelectrics or thermal bubble ejection, accelerometers for cars, e.g. for airbag deployment in collisions, gyroscopes, silicon pressure sensors, e.g. for monitoring car tires or blood pressure, optical switching technology or bio-MEMS applications in medical and health-related technologies.

Addition of CHF₃ increases selectivity of the etching to the photo-resist, and achieves more efficient etching results, enabling plasma-etch for items having a sub-micron photoresist and an inorganic substrate, e.g. an inorganic layer of silicon, silicon dioxide, silicon nitride or any of the low-k dielectrics mentioned above.

In one aspect, the etchant compositions of the present invention are preferably in gaseous form and thus are gas mixtures.

In another aspect of the invention, the etchant compositions are at least partially in condensed form, e.g. being pressurized or kept at low temperature.

In this embodiment, the mixtures are liquid or a composition matter in a partially liquid and partially gaseous state. If these mixtures are compressed in a storage tank (e.g. in a pressure cylinder, a tank or the like), a gas phase may form above the condensed liquid.

If desired, the etchant composition of the present invention may be applied in the presence of an inert gas, e.g. in the presence of at least one inert gas selected from the group consisting of nitrogen, helium, xenon and argon. In this embodiment, the inert gas is preferably present in a range from >0 -50 % by volume, preferably in a range from10 ― 25 % by volume. In this embodiment, mixtures of etchant composition and inert gas may be introduced into the plasma apparatus, or the etchant composition and the inert gas, or even all components, may be introduced separately into the plasma apparatus.

For the etching of an item having a photoresist layer coated on a Si₃N₄ layer, the etchant composition may further comprise at least one oxygen compound selected from the group consisting of oxygen and N₂O wherein the total amount of any oxygen compound is equal to or lower than 10 % by volume of the total content of COF₂, CHF₃ and oxygen compound set as 100 % by volume.

The conditions during the plasma-etching, e.g., etching rate, etching time, pressure in the plasma chamber etc., correspond to those usually applied. For example, direct plasma or indirect plasma can be applied. The plasma may be generated by applying any suitable frequency ; often, a frequency of 13.56 MHz may be applied. If desired, the process can be assisted by a radio frequency of equal to or greater than 15 MHz to generate plasma

Preferably, the at least one sub-micron layer of the photoresist forms a coating on a a substrate having a layer comprising at least one compound selected from the group consisting of silicon oxides, silicon nitrides and any mixture thereof.

While any conventional plasma-etching methods can be applied to the present invention, the etching technique described WO 2000/30168 directed to the production of silicon integrated circuits is explained herewith in detail for the exemplary disclosure. The WO 2000/30168 generally concerns the etching of silicon integrated circuits, and especially the etching of dielectrics, for example, silicon oxide and related materials in a process that is capable of greatly reduced etching rates for silicon nitride and other non-oxide materials but still producing a vertical profile in the oxide. Most often, the circuit comprises a silicon base with a polysilicon gate later attached thereto. A silicon nitride layer serves as electrical insulator. The silicon nitride layer and the polysilicon gate layer are in turn covered by an oxide layer, and a photo-resist layer is deposited over the oxide layer. The photo-resist layer is photographically defined into a mask. A subsequent etching step etches a contact hole through the oxide layer and stops on the silicon nitride layer.

The minimum feature sizes of contact via holes penetrating the oxide layer are continuously decreasing. The node, i.e. the distance between the walls of the etched items (e.g. contacts and holes), is permanently minimized. Light with a wavelength of 248 nm or 193 nm was applied for 130 nm nodes. For nodes with a wall distance of 90 nm and below, light with a wavelength of 193 nm is applied, and light with a wavelength of 157 nm to produce 65 nm nodes. The minimum feature size of contact and via holes is or will be shrinking to 45 nm, 32 nm and even only 22 nm. The immersion lithography technique allows achieving definitions which can extend the use of this light source to the 32 nm node. "Extreme UV light" will supposedly be applied for the 22 nm node in the future. Some information about EUV light, e.g. EUV light with a wavelength of 13.5 nm, can be found in US patent 7,372,059. Another technique which can be used to extend the application of the 193 nm light is the so called the "double patterning method." It allows for the application of light of rather long wavelength, e.g. 193 nm, to produce very narrow nodes, e.g. even those with 90 nm nodes and gaps lower than 90 nm. A first photo-resist is formed and developed, and then, a second photo-resist is developed. This method is for example described in WO 2008/036496.

In another aspect, the present invention provides a composition of matter comprising COF₂ and CHF₃ wherein the content of CHF₃ in the composition of matter is in a range of 5∼40 %, preferably 10∼40 %, more preferably 15∼40 %, when the total amount of COF₂ and CHF₃ is set to 100 % by volume.

The composition of matter can be applied together with a diluent compound. Preferably, the diluent compound is compound which is gaseous at 1 bar (abs) et 25°C. Preferably, the diluent is at least one compound selected from the group consisting of nitrogen, helium argon and xenon. In this embodiment, the diluent is contained in the diluted composition in an amount from 1 to 70 % by volume. Preferred compositions of this embodiment comprise 10 to 30 parts by volume of the sum of COF₂ and CHF₃; 60 to 80 parts by volume of Ar and 5 to 15 parts of N₂.

The composition of matter may further comprise at least one oxygen compound selected from the group consisting of oxygen and N₂O wherein the total amount of any oxygen compound is equal to or lower than 10 % by volume of the total content of COF₂, CHF₃ and oxygen compound set as 100 % by volume.

The composition of matter, with or without diluent, of the present invention can be applied, for example, as etchant composition in the process of the present invention.

The following examples are intended to illustrate the invention in further detail, without limiting it.

### EXAMPLE 1 : Manufacture of a mixture comprising COF₂ and CHF₃

COF₂ and CHF₃ are fed in gaseous form into a steel tank in a volume ratio of 4 : 1 until a pressure of 60mTorr (abs) is achieved.

### EXAMPLE 2 : Plasma etching using a mixture of comprising COF₂ and CHF₃

A 550 nm plasma nitride (PN) film is formed over bulk-Si, and then, - 500 nm AR 80 positive photo-resist layer is deposited over the PN film and i-line stepper structures down to 0, 3 µm, holes and lines. Then, plasma-etching is conducted in plasma chamber, such as EMXP+ MERIE chamber available from Applied Materials, by delivering an etchant composition consisting of COF₂:CHF₃ in a volume ratio of 4 : 1 into the plasma reactor, with the etch rate of 350 nm/min and etch time of over 20 sec. The profile of the resulting item is almost 90° taper angle for contact holes and for lines with a diameter of 361.6 nm and a depth of 515.1 nm, and simultaneously, residue-free etching result is obtained. A selectivity to the photo-resist is sufficient for holes with aspect ratio of > 2:1.

Should the disclosure of any patents, patent applications, and publications which are incorporated herein by reference conflict with the description of the present application to the extent that it may render a term unclear, the present description shall take precedence.

## Claims

1. A process for producing an etched item having a sub-micron photoresist layer comprising a step of plasma etching at least one inorganic substrate, wherein the etchant composition comprises COF₂ and CHF₃.

2. The process of claim 1, wherein the content of CHF₃ is in a range of 5∼40 %, preferably 10∼40 %, more preferably 15∼40 % when the total amount of COF₂ and CHF₃ is set to 100 vol.- %.

3. The process of any one of claims 1 to 2, wherein the thickness of the sub-micron layer is in the range of 1 nm - 999 nm.

4. The process of any one of claims 1 to 3, wherein the pressure for the step of plasma etching is 10 - 200 mTorr, preferably 20 ― 150 mTorr, more preferably 60 -100 mTorr.

5. The process of any one of claims 1 to 4, wherein the item is an electronic device selected from the group consisting of semiconductors, solar cells and display panels.

6. The process of any one of claims 1 to 5, wherein the at least one sub-micron layer is present as a coating over a layer selected from the group consisting of silicon oxides, silicon nitrides and any mixture thereof.

7. The process of any one of claims 1 to 8, wherein the etchant composition further comprising at least one inert compound selected from the group consisting of nitrogen, helium, xenon and argon.

8. The process of any one of claims 1 to 7 for the etching of a photoresist layer coated on a Si₃N₄ layer, wherein the etchant composition further comprises at least one compound selected from the group consisting of oxygen and N₂O in an amount equal to or lower than 10 % by volume of the total amount of the etchant composition, inert compound and oxygen, N₂O or the sum of oxygen and N₂O.

9. A composition of matter comprising COF₂ and CHF₃ wherein the content of CHF₃ in total amount of COF₂ and CHF₃ is in a range of 5∼40 %, preferably 10∼40 %, more preferably 15∼40 %.

10. The composition of matter of claim 9, further comprising at least one diluent compound selected from the group consisting of nitrogen, helium, xenon and argon.

11. The composition of matter of anyone of claims 9 and 10 comprising 10 to 30 parts by volume of the mixture of COF₂ and CHF₃, 60 to 80 parts by volume of Ar and 5 to 15 parts of N₂.

12. The composition of matter of any one of claims 9 to 11 further comprising at least one oxygen compound selected from the group consisting of oxygen and N₂O wherein the total amount of any oxygen compound is equal to or lower than 10 % by volume of the total content of COF₂, CHF₃ and oxygen compound set as 100 % by volume.
